# FASCICULE DE BREVET EUROPEEN

(11) **EP 1 829 043 B1**
(45) Date de publication et mention de la délivrance du brevet: **15.01.2020**
(21) Numéro de dépôt: 05825868.2
(22) Date de dépôt: 20.12.2005
(51) Int. Cl.: G11C 13/00, H01L 45/00, H01L 27/24

(54) **MEMOIRE PMC AYANT UN TEMPS DE RETENTION ET UNE VITESSE D'ECRITURE AMELIORES**
PMC-SPEICHER MIT VERBESSERTER HALTEZEIT UND SCHREIBGESCHWINDIGKEIT
PMC MEMORY WITH IMPROVED RETENTION TIME AND WRITING SPEED

(30) Priorité: 23.12.2004 FR 0453210
(43) Date de publication de la demande: 05.09.2007
(73) Titulaire: Commissariat à l'Énergie Atomique et aux Énergies Alternatives, 75015 Paris (FR)
(72) Inventeur: SOUSA, Véronique, F-38000 Grenoble (FR)
(74) Mandataire: Moutard, Pascal Jean
(86) Numéro de dépôt international: PCT/FR2005/051114
(87) Numéro de publication internationale: WO 2006/070151

(56) Documents cités:
- US-A- 5 933 365
- US-A1- 2003 123 282
- US-A1- 2003 209 728
- US-A1- 2003 209 971
- PATENT ABSTRACTS OF JAPAN vol. 012, no. 066 (P-671), 27 février 1988 (1988-02-27) -& JP 62 205598 A (HITACHI LTD), 10 septembre 1987 (1987-09-10)

## Description

### DOMAINE TECHNIQUE ET ART ANTÉRIEUR

L'invention concerne le domaine des mémoires ré-inscriptibles, plus particulièrement non volatiles.

En fonction des applications et des performances visées, différents types de mémoires sont utilisées.

Lorsque des temps d'écriture ultra-rapides sont requis (comme lors de calcul par un microprocesseur par exemple), on fait appel aux mémoires SRAM constituées par l'agencement de plusieurs transistors.

L'inconvénient de ces mémoires est qu'elles sont volatiles et que la taille du point mémoire, relativement grande, ne permet pas une grande capacité de stockage.

Pour une grande capacité de stockage, on utilise les mémoires DRAM qui consistent à stocker des charges électriques sur une capacité.

Ces mémoires présentent des temps d'écriture plus élevés (quelques 10ns) et elles sont aussi volatiles, le temps de rétention de l'information étant de l'ordre de quelques 10 ms. Enfin, pour des applications qui nécessitent un stockage de l'information même lorsque la tension est coupée, on utilise des mémoires EEPROM ou mémoires FLASH qui permettent de stocker des charges sur la grille flottante d'un transistor à effet de champ. Ces mémoires sont non volatiles. Les inconvénients de ce type de mémoire sont les temps d'écriture longs (quelques micro-secondes) et la cyclabilité limitée à 10E6 cycles d'écriture.

Le principe de fonctionnement des mémoires non volatiles réinscriptibles utilisées actuellement (mémoires EEPROM ou Flash) repose sur le stockage de charges électriques sur la grille flottante de transistors à effet de champ.

Chaque point mémoire est donc constitué de un ou plusieurs composants silicium dont la réduction de taille conduit à une diminution du signal de lecture et une diminution de la durée de rétention de l'information. On comprend donc que la densité de ce type de mémoire est limitée.

De plus, ces mémoires présentent des temps d'écriture relativement longs (quelques micro-secondes) car c'est le temps nécessaire pour que les électrons passent sur la grille flottante par effet tunnel.

Ces mémoires sont également limitées en cyclabilité (10⁶). En effet, la rétention diminue au fur et à mesure des cycles d'écriture car la création de défauts dans l'oxyde permet aux électrons de s'échapper de la grille flottante.

Différents concepts de mémoires sont envisagés pour les nouvelles générations de mémoires non volatiles réinscriptibles.

Les matériaux actifs peuvent être des matériaux ferro-électriques (mémoires FERAM), ou magnétiques (mémoires MRAM), ou à changement de phase (mémoires PC-RAM) ou à conduction ionique (mémoires PMC) .

L'invention s'adresse notamment au domaine des mémoires PMC.

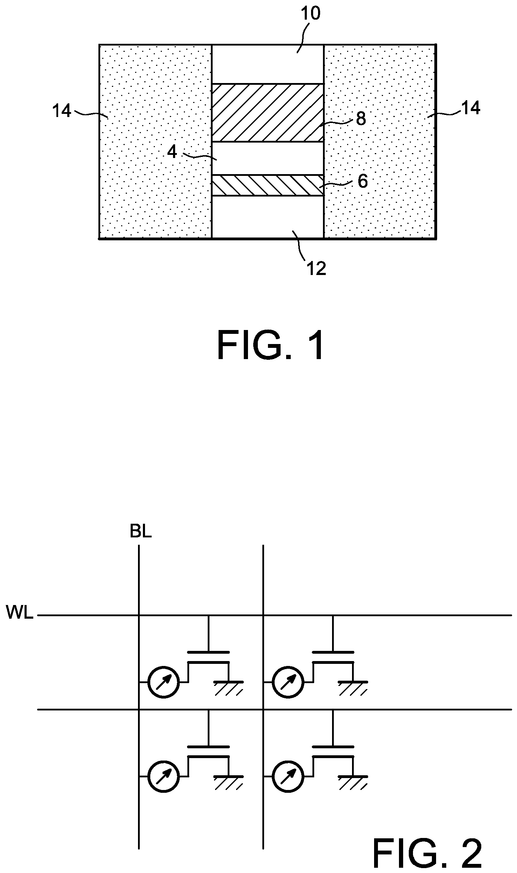

Une cellule mémoire PMC et une matrice de points mémoires selon l'art antérieur sont respectivement présentées sur figures 1 et 2.

Le principe de fonctionnement des mémoires PMC repose sur la migration d'ions (par exemple Ag+) dans un électrolyte solide 4 (par exemple GeSe) placé entre une cathode inerte 6 (par exemple en Ni) et une anode soluble 8 (par exemple en Ag).

Les références 10, 12 représentent des points de contact, et la référence 14 un milieu isolant.

Le signal de lecture résulte de la différence de résistivité électrique entre deux états ON et OFF.

A l'état OFF, des ions sont dispersés dans la matrice formant une phase de grande résistivité. En appliquant une différence de potentiel de quelques 100mV entre l'anode et la cathode sous la forme d'une impulsion de quelques 10ns, les ions migrent vers la cathode 6 en formant un dépôt métallique. On obtient ainsi l'état ON, de basse résistivité.

En appliquant une différence de potentiel de même intensité et durée mais de signe opposé, le dépôt métallique se redissout sous forme d'ions dans l'électrolyte et on revient à l'état OFF.

La figure 2 représente une matrice de 4 points mémoires PMC tels que décrits ci-dessus, commandés par des signaux de ligne WL et de colonnes BL.

Le principal avantage des mémoires PMC réside dans le fait que les tensions d'écriture, inférieures à 1V, sont faibles par rapport à celle des autres mémoires non volatiles (EEPROM, MRAM, PCRAM).

L'inconvénient des mémoires PMC telles que décrites dans l'état de l'art (comme par exemple dans le brevet US - 5761115) est qu'elles ne permettant pas d'obtenir à la fois un temps d'écriture court et un temps de rétention long, ces 2 paramètres variant en sens opposé : lorsqu'on atteint une vitesse d'écriture rapide, le temps de rétention est trop court, et lorsque ce dernier devient plus long, on constate en général un ralentissement de l'écriture.

Il se pose donc le problème de trouver une mémoire de type PMC dont la structure et le fonctionnement soient compatibles avec un temps d'écriture rapide et un temps de rétention long. Le document US2003/0209971 propose d'utiliser une énergie thermique pour écrire une cellule PMC.Le document US2003/0209728 propose une méthode d'écriture d'une mémoire PMC. Ces deux documents forment le préambule de la revendication 1.

### EXPOSÉ DE L'INVENTION

L'invention concerne une mémoire PMC dont à la fois le temps de rétention et la vitesse d'écriture sont optimisés.

L'invention propose une structure PMC comportant un élément chauffant pour que la température du matériau actif au moment de l'écriture augmente localement et transitoirement.

L'invention concerne une mémoire selon la revendication 1 ainsi que son procédé de fonctionnement tel que décrit par la revendication 16.

Une mémoire PMC selon l'invention voit sa température augmenter localement au niveau du point mémoire et transitoirement au moment de l'écriture.

On appelle température de fonctionnement (Tf) de la mémoire, la température d'un point mémoire en dehors de l'étape d'écriture. En général, lorsque la mémoire est utilisée, cette température est un peu supérieure à la température ambiante, de l'ordre de 80°C.

On appelle température d'écriture (Te) de la mémoire la température atteinte pendant l'étape d'écriture. Dans les mémoires PMC de l'état de l'art, la température d'écriture Te est égale à la température de fonctionnement Tf.

Dans une structure PMC de l'art antérieur, les températures Te et Tf sont confondues.

Dans une structure PMC selon l'invention, la température d'écriture Te est supérieure à la température de fonctionnement Tf, tout en restant inférieure à la température de transition vitreuse du matériau constitutif de l'élément actif de la mémoire, par exemple du chalcogénure amorphe.

L'invention différencie les températures Te et Tf et permet d'obtenir un meilleur compromis entre la vitesse d'écriture et le temps de rétention.

En utilisant une telle mémoire à écriture assistée thermiquement, on augmente localement et transitoirement la température du point mémoire au moment de l'écriture, par exemple à une température comprise entre 300 K et 450 K.

L'invention permet d'utiliser un système dont le coefficient de diffusion chimique est faible à la température de fonctionnement de la mémoire, mais dont le coefficient de diffusion sous champ électrique est élevé au cours de l'écriture.

Il en résulte une augmentation, à la fois, du temps de rétention et de la vitesse d'écriture.

L'invention permet donc l'optimisation de la vitesse d'écriture et du temps de rétention d'une mémoire PMC.

La cellule mémoire peut comporter un électrolyte solide comportant un matériau de type chalcogénure, pouvant être dopé métal, par exemple de type AgGeSe ou de type AgGeSbSe ou de type AgGeS ou de type AsS.

L'électrolyte solide peut être un oxyde, par exemple WO3.

Des moyens peuvent en outre être prévus pour former une barrière thermique, en particulier du côté opposé aux moyens de chauffage dans la cellule.

Les moyens de chauffage peuvent être placés à proximité de la zone active, ou en être séparés par au moins une électrode.

Ils peuvent être placés en contact avec la cathode inerte, ou en être séparés par au moins une électrode de contact de la cathode inerte.

Une mémoire selon l'invention peut comporter 3 contacts, dont un commun aux moyens de chauffage et à la cellule, ou 4 contacts, dont deux pour les moyens de chauffage et deux pour la cellule.

Grâce au choix des compositions des matériaux, on peut contrôler la vitesse de diffusion du métal dans la zone active ainsi que la variation de cette vitesse avec la température.

La structure de la cellule, en particulier la position relative de l'élément chauffant et de l'élément actif dans la cellule, peut en outre être optimisée pour obtenir une écriture assistée thermiquement.

Il en va de même des paramètres d'impulsion d'écriture, et d'impulsion de chauffage.

L'invention concerne également une matrice de mémoires de type PMC telles que décrit ci-dessus, comportant des moyens d'adressage de lignes, des moyens d'adressage de colonnes, et des moyens d'adressage des éléments de chauffage.

### BRÈVE DESCRIPTION DES DESSINS

- La figure 1 représente un dispositif de type PMC connu,
- la figure 2 représente une matrice de mémoires PMC selon l'art antérieur,
- les figures 3A - 3C représentent trois modes de réalisation de l'invention,
- la figure 4 représente une matrice de mémoires PMC selon l'invention,
- la figure 5 représente un résultat de simulation électro-thermique montrant le réchauffement local d'une mémoire PMC selon l'invention,
- la figure 6 représente un autre mode de réalisation de l'invention.

### EXPOSÉ DÉTAILLÉ DE MODES DE RÉALISATION PARTICULIERS

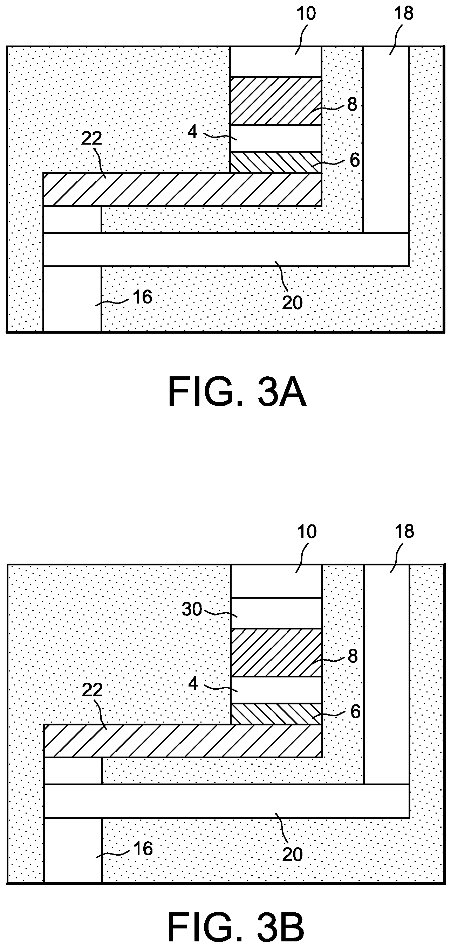

Un premier exemple d'une mémoire PMC selon l'invention est illustré sur la figure 3A.

Un élément chauffant 20, tel qu'une résistance chauffante, est placé à proximité de la zone active 4. Il peut être activé par deux contacts 16, 18.

En fonctionnement, il est traversé par un courant et produit de la chaleur par effet Joule, chaleur transmise à la zone active 4 par conduction.

On peut associer à chaque élément actif un élément chauffant selon le schéma de principe de la figure 3A.

Pour augmenter l'efficacité du chauffage, on peut ajouter une barrière thermique 30 du côté opposé à l'élément chauffant, comme illustré sur la figure 3B. Cette barrière est par exemple placée entre l'anode 8 et le contact 10.

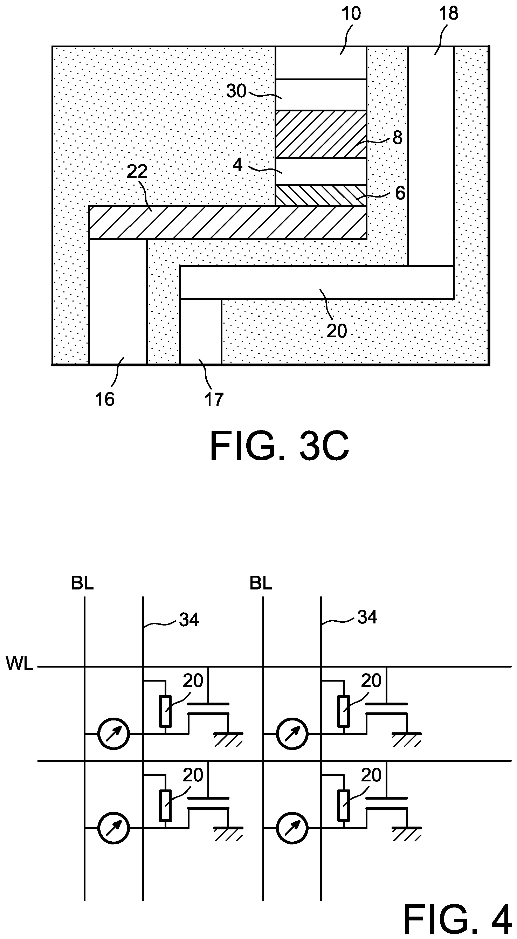

Un autre exemple est donné en figure 3C, où les moyens de chauffage sont indépendants de l'élément actif : on a alors 4 plots 10, 16, 17, 18, deux pour l'élément actif et deux pour l'élément de chauffage.

Dans les trois cas, la structure peut être encore optimisée en rapprochant l'élément chauffant au plus près de l'élément actif 4, mais en évitant tout court circuit entre l'anode et la cathode.

Un schéma d'une matrice de points mémoire selon l'invention est présenté sur la figure 4 : par rapport à la configuration de base (figure 2), une ligne 34 est ajoutée, qui permet de faire passer le courant à travers chaque élément chauffant 20.

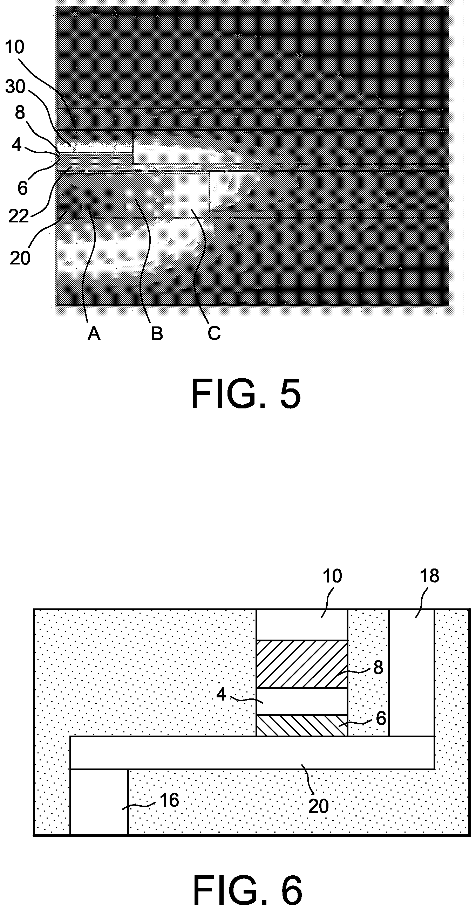

Le résultat de la simulation électro-thermique de cette structure, représenté en figure 5, montre un échauffement local du point mémoire, pendant l'écriture, de 140 K. Les conditions de la simulation sont les suivantes : élément actif en AgGeSe de diamètre 1 µm, élément chauffant en TiN, impulsion de chauffage de 0,6 V, présence d'une barrière thermique supérieure (figure 3B). Sur cette figure on retrouve les éléments d'un point mémoire selon l'invention, avec les références de la figure 3B. La zone A est la zone dont les températures sont les plus élevées, puis vient la zone B, de températures moins élevées que la zone A, puis vient la zone C, de températures encore moins élevées que la zone B.

D'autres configurations conduisant à un échauffement local et transitoire pendant l'étape d'écriture sont possibles, par exemple celle proposée sur la figure 6 : un élément chauffant 20 est placé directement sous la cathode inerte 6, aucun contact n'étant établi entre l'anode 8 et la cathode 6. L'élément chauffant 20 peut même être utilisé comme cathode 6.

On a alors un dispositif à 3 contacts 10, 16, 18, l'application d'une tension entre les contacts 10 et 16 permettant l'écriture dans la cellule 4, l'application d'une tension entre les contacts 16 et 18 permettant le chauffage.

On peut optimiser la configuration, les dimensions, le matériau de l'élément chauffant en fonction de l'élévation de température désirée grâce à des simulations électro-thermiques.

Pour ces simulations, on peut utiliser un logiciel de modélisation multiphysique commercial comme par exemple le logiciel FEMLAB qui a permis d'obtenir les résultats présentés sur la figure 5.

L'invention permet une dissociation des phénomènes de rétention et d'écriture par augmentation locale et transitoire de la température au moment de l'écriture.

Elle permet d'optimisation du temps de rétention et de la vitesse d'écriture.

Différents matériaux, en particulier de type chalcogénures peuvent être utilisés dans le cadre de l'invention.

Le Tableau I mentionne les propriétés de différents matériaux chalcogénures dopés Ag : dans ce tableau, Tg représente la température de transition vitreuse, G représente le rapport des flux de migration à 300 K et 450 K (G est aussi égal au rapport des conductivités ioniques à ces deux températures). Les données sont extraites des documents suivants : E. Bychkov et al., « Percolation transition in Ag doped gemanium chalcogenide based glasses: conductivity and silver diffusion », Journal of non-crystalline solids 208 (1996) p1, pour les matériaux 2 - 4, et M. Kawasaki et al., « Ionic conductivity of Agx(GeSe3)1-x glasses », Solid State Ionics 123 (1999) p.259, pour le matériau 1.

**Tableau 1**

| **Propriétés des matériaux chalcogénures dopés Ag** | | | | | | | | |
|---|---|---|---|---|---|---|---|---|
| **n°** | **Matériau** | **at% Ag** | **Tg (°C)** | **σ** ((**Ω⁻¹**.**cm⁻¹**) **@300K** | **σ (Ω⁻¹.cm⁻¹) @450K** | **Ea (eV)** | **G** | **D (cm².s⁻¹) (300K)** |
| 1 | Ag₂₅Ge₁₉Se₅₆ | 25 | 240 | 2.6e⁻⁴ | 1.2e⁻² | 0.33 | 50 | Pas de données |
| 2 | Ag₂₅Ge₂₉S₄₆ | 25 | 330 | 7e⁻⁶ | 7.5e⁻⁴ | 0.393 | 110 | 3.e⁻¹¹ |
| 3 | AgGeS | 20 | 300 | 3e⁻⁸ | 3.3e⁻⁶ | 0.395 | 110 | 1e⁻¹² |
| 4 | Ag₂₂Ge₂₂Sb₉Se₄₇ | 22.5 | ? | 1.7e⁻⁵ | 1.9e⁻³ | 0.395 | 110 | 5e⁻¹¹ |

Les avantages de chacun de ces matériaux employé en combinaison avec l'invention sont les suivants.

Matériau n°1 : C'est le matériau utilisé dans l'art antérieur. Un dispositif selon l'invention mettant en œuvre ce matériau permet de multiplier la vitesse d'écriture par 50 sans dégrader le temps de rétention (G correspond au facteur permettant de multiplier la vitesse d'écriture).

Matériau n°2 : C'est un autre matériau dans lequel l'élément chalcogène n'est plus Se mais S. Ce matériau est utilisé pour sa plus haute température de transition vitreuse, malgré une vitesse d'écriture plus faible que le matériau n°1. Un dispositif selon l'invention mettant en œuvre ce matériau permet de retrouver une vitesse d'écriture plus élevée qu'avec le matériau n°1 tout en gardant le bénéfice de la température de transition vitreuse plus élevée du matériau n°2.

Matériau n°3 : Il s'agit du matériau n°2, avec une plus faible teneur en Ag. C'est un matériau qui n'est pas classiquement utilisé car la vitesse d'écriture attendue est faible. Un dispositif selon l'invention mettant en œuvre ce matériau permet de retrouver la vitesse d'écriture du matériau n°2 en bénéficiant d'un temps de rétention 30 fois plus grand. La température de transition vitreuse est également plus élevée que pour le matériau n°1. Ce matériau constitue un bon compromis.

Matériau n°4 : C'est le matériau n°1 avec une plus faible teneur en élément chalcogène obtenue en remplaçant une partie des atomes Se par Sb. En diminuant la teneur en élément chalcogène, on attend une plus faible vitesse de diffusion de Ag. C'est pourquoi ce matériau n'est pas classiquement utilisé car sa vitesse d'écriture attendue est faible. Un dispositif selon l'invention mettant en œuvre ce matériau permet d'obtenir à la fois une vitesse d'écriture et un temps de rétention améliorés par rapport au matériau n°1.

Dans ces exemples et dans un souci de comparaison, il a été supposé que la température d'écriture Te est de 450K, car cette température est inférieure aux températures de transition vitreuse de tous les matériaux évoqués. Il est possible d'augmenter la température d'écriture jusqu'à la température de transition vitreuse des matériaux dans chacun des cas pour augmenter encore la vitesse d'écriture.

Selon un exemple une cellule selon l'invention peut avoir les dimensions typiques suivantes :
- diamètre du plot de chalcogénure photodopé : inférieur à 1 µm, de préférence inférieur à 0.1 µm,
- diamètre de l'élément chauffant 20: du même ordre de grandeur que le diamètre ou la taille maximale du plot de chalcogénure dopé et de préférence supérieur au diamètre du plot de chalcogénure ; de préférence encore le diamètre de l'élément chauffant est inférieur à 1µm et de préférence encore inférieur à 0.1 µm.
- épaisseur des couches :
   a - électrodes inférieure 6 et supérieure 8 : 50 nm - 200 nm,
   b - chalcogénure photodopé 4, d'épaisseur comprise entre 20 nm et 40 nm,
   c - élément chauffant 20 : épaisseur comprise entre 100 nm et 200 nm.

A titre d'exemple une cellule selon l'invention peut mettre en oeuvre les compositions suivantes de métaux et de chalcogénures :
1er exemple : le métal est Ag et le chalcogénure est GeSe, ou GeS, ou GeSbSe
2ème exemple : le métal est Cu et le chalcogénure est AsS.

Un premier exemple de procédé pour réaliser un dispositif selon l'invention va être donné. Il s'agit là du dispositif décrit ci-dessus en relation avec la figure 3A.

Il est tout d'abord procédé à la réalisation des transistors d'adressage.

On réalise ensuite le contact inférieur 16 de l'élément chauffant 20, puis l'élément chauffant 20 lui-même.

L'isolant est ensuite déposé.

Il est ensuite procédé à la fabrication du contact inférieur 22 de l'élément actif, puis à la réalisation de l'électrode inférieure 22.

Un tricouche est alors déposé : cathode inerte 6/chalcogénure 4/métal ; puis il y a photodissolution. On dépose ensuite l'anode.

Puis, cet empilement est lithographié et gravé en forme de plot.

Un matériau isolant (eg SiO2) est déposé puis planarisé.

On fabrique ensuite l'électrode supérieure 10. Enfin, le contact 18 vers l'élément chauffant est repris.

Un deuxième exemple de procédé pour réaliser un dispositif selon l'invention va être donné. Il s'agit là du dispositif décrit ci-dessus en relation avec la figure 6.

Il est tout d'abord procédé à la réalisation des transistors d'adressage.

On réalise ensuite le contact inférieur 16 de l'élément chauffant, puis l'élément chauffant 20 lui-même.

Un tricouche est alors déposé : cathode inerte 6/chalcogénure 4/métal ; puis il y a photodissolution. On dépose ensuite l'anode.

Puis, cet empilement est lithographié et gravé en forme de plot.

Un matériau isolant (eg SiO2) est déposé puis planarisé.

On fabrique ensuite l'électrode supérieure 10. Enfin, le contact 18 vers l'élément chauffant est repris.

L'invention s'applique aux mémoires réinscriptibles non volatiles de type PMC.

L'invention permet, par chauffage local et transitoire par un élément chauffant pendant la période d'écriture, l'optimisation séparée du temps de rétention et la vitesse d'écriture dans une mémoire PMC.

Lors de l'écriture, une température d'environ 150 °C peut être atteinte, favorisant le coefficient de diffusion des espèces dans la zone active, sous champ électrique, et donc la vitesse d'écriture.

Puis, une température plus faible, par exemple d'environ 80°C, permet d'obtenir un temps de rétention amélioré sans dissolution spontanée du dépôt conducteur.

Une diffusion et une migration rapides du métal dans la zone active, sous champ électrique, pendant l'écriture, sont atteintes grâce à un coefficient de diffusion élevé à la température d'écriture (∼150°C). Il en résulte une vitesse d'écriture améliorée.

Selon l'invention, les éléments chauffants, tels que des résistances chauffantes, sont placés en parallèle avec les éléments actifs. Le matériau actif est très résistif et traversé par un faible courant. Le chauffage est réalisé par des éléments de chauffage localisés au point mémoire.

## Revendications

1. Mémoire à conduction ionique PMC comportant une cathode inerte (6), une anode soluble (8) et un électrolyte solide (4) placé entre ladite cathode et ladite anode, **caractérisée en ce qu'**elle comporte une résistance (20) chauffante pour chauffer l'électrolyte solide, située à proximité de ce dernier, pour porter celui-ci, transitoirement lors d'une écriture dans la mémoire, à une température d'écriture supérieure à sa température de fonctionnement en dehors de l'étape d'écriture.

2. Mémoire selon la revendication 1, l'électrolyte solide comportant un matériau de type chalcogénure.

3. Mémoire selon la revendication 2, l'électrolyte solide étant un oxyde, par exemple WO3.

4. Mémoire selon la revendication 2 ou 3, le chalcogénure étant dopé avec un métal.

5. Mémoire selon la revendication 4, dans laquelle le chalcogénure dopé métal est de type AgGeSe.

6. Mémoire selon la revendication 4, dans laquelle le chalcogénure dopé métal est de type AgGeSbSe.

7. Mémoire selon la revendication 4, dans laquelle le chalcogénure dopé métal est de type AgGeS.

8. Mémoire selon la revendication 2, dans laquelle le chalcogénure est de type AsS.

9. Mémoire selon la revendication 4, dans laquelle le chalcogénure dopé métal est de type AsS dopé cuivre.

10. Mémoire selon l'une des revendications 1 à 9, comportant en outre des moyens (30) formant barrière thermique du côté opposé à l'élément chauffant.

11. Mémoire selon l'une des revendications 1 à 10, la résistance (20) chauffante étant placée en contact avec la cathode inerte (6).

12. Mémoire selon l'une des revendications 1 à 11, la résistance chauffante (20) étant séparée de la cathode inerte (6) par au moins une électrode (22) de contact de la cathode inerte (6).

13. Mémoire selon l'une des revendications 1 à 12, comportant un premier contact, un deuxième contact et un troisième contact (10, 16, 18), le premier et le deuxième contacts (10, 16) étant prévus pour l'application d'une tension entre la cathode inerte (6) et l'anode soluble (8) permettant l'écriture dans l'électrolyte solide (4), l'un de ces deux contacts étant commun à la résistance (20) chauffante, cette dernière pouvant être activée par application d'une tension entre ce contact commun et le troisième contact (18).

14. Mémoire selon l'une des revendications 1 à 12, comportant 4 contacts (10, 16, 17, 18), dont deux contacts (10, 16) pour l'application d'une tension entre la cathode inerte (6) et l'anode soluble (8), permettant l'écriture dans l'électrolyte solide (4), et deux contacts (17, 18) pour l'activation de la résistance (20) chauffante.

15. Matrice de mémoires à conduction ionique selon l'une des revendications 1 à 14, comportant des moyens d'adressage de lignes (WL), des moyens d'adressage de colonnes (BL), et des moyens d'adressage des résistances (20) chauffantes.

16. Procédé de fonctionnement d'une mémoire à conduction ionique selon l'une des revendications 1 à 14, dans lequel, lors d'une phase d'écriture dans la mémoire :
- on applique une tension d'écriture à l' l'électrolyte solide (4),
- à l'aide de la résistance (16, 18, 20) chauffante, on porte l'électrolyte solide (4) transitoirement, à une température d'écriture supérieure à sa température de fonctionnement en dehors de l'étape d'écriture.

17. Procédé selon la revendication 16, dans lequel, lors d'une phase d'écriture, la température de l'électrolyte est portée à une valeur comprise entre 353,15 K et 450 K.

## Patentansprüche

1. Ionenleitfähiger PCM-Speicher, umfassend eine inerte Kathode (6), eine Lösungsanode (8), und einen festen Elektrolyten (4), angeordnet zwischen der genannten Kathode und der genannten Anode, **dadurch gekennzeichnet, dass** er einen Heizwiderstand (20) umfasst, um den festen Elektrolyten zu beheizen, der sich in der Nähe dieses Letzteren befindet, um diesen vorübergehend während eines Einschreibens in den Speicher auf eine Schreibtemperatur höher als seine Betriebstemperatur außerhalb des Schreibschritts zu bringen.

2. Speicher nach Anspruch 1, wobei der feste Elektrolyt ein Material des Chalkogenid-Typs umfasst.

3. Speicher nach Anspruch 2, wobei der feste Ektrolyt ein Oxid ist, zum Beispiel WO3.

4. Speicher nach Anspruch 2 oder 3, wobei das Chalkogenid mit einem Metall dotiert ist.

5. Speicher nach Anspruch 4, bei dem das metalldotierte Chalkogenid vom Typ AgGeSe ist.

6. Speicher nach Anspruch 4, bei dem das metalldotierte Chalkogenid vom Typ AgGeSbSe ist.

7. Speicher nach Anspruch 4, bei dem das metalldotierte Chalkogenid vom Typ AgGeS ist.

8. Speicher nach Anspruch 2, bei dem das metalldotierte Chalkogenid vom Typ AsS ist.

9. Speicher nach Anspruch 4, bei dem das metalldotierte Chalkogenid vom Typ kupferdotiertes AsS ist.

10. Speicher nach einem der Ansprüche 1 bis 9, mit außerdem Einrichtungen (30), die auf der dem Heizelement entgegengesetzten Seite eine thermische Barriere bilden.

11. Speicher nach einem der Ansprüche 1 bis 10, wobei der Heizwiderstand (20) in Kontakt mit der inerten Kathode (6) platziert ist.

12. Speicher nach einem der Ansprüche 1 bis 11, wobei der Heizwiderstand (20) von der inerten Kathode (6) getrennt ist durch mindestens eine Kontaktektrode (22) der inerten Elektrode (6)

13. Speicher nach einem der Ansprüche 1 bis 12, mit einem ersten Kontakt, einem zweiten Kontakt und einem dritten Kontakt (10, 16, 18), wobei der erste und der zweite Kontakt (10, 16) vorgesehen sind zum Anlegen einer Spannung zwischen der inerten Kathode (6) und der Lösungsanode (8), was das Einschreiben in den festen Elektrolyten (4) ermöglicht, wobei einer dieser beiden Kontakte gemeinsam mit dem Heizwiderstand (20) ist, wobei dieser Letztere aktiviert werden kann durch das Anlegen einer Spannung zwischen diesem gemeinsamen Kontakt und dem dritten Kontakt (18).

14. Speicher nach einem der Ansprüche 1 bis 12, mit vier Kontakten (10, 16. 17, 18), davon zwei Kontakte (10, 16) für das Anlegen einer Spannung zwischen der inerten Kathode (6) und der Lösungsanode (8), was das Einschreiben in den festen Elektrolyten (4) ermöglicht, und zwei Kontakte (17, 18) zur Aktivierung des Heizwiderstands (20).

15. Ionenleitfähige Speichermatrix nach einem der Ansprüche 1 bis 14, mit Zeilenadressiereinrichtungen (WL), Spaltenadressiereinrichtungen (BL) und Adressiereinrichtungen der Heizwiderstände (20).

16. Betriebsverfahren eines ionenleitfähigen Speichers nach einem der Ansprüche 1 bis 14, bei dem, während einer Speicher-Einschreibphase :
- man eine Schreibspannung an den festen Elektrolyten (4) anlegt,
- man mit Hilfe des Heizwiderstands (16, 18, 20) den festen Elektrolyten (4) vorübergehend auf eine Schreibtemperatur höher als seine Betriebstemperatur außerhalb des Schreibschritts bringt,

17. Verfahren nach Anspruch 16, bei dem, während einer Schreibphase, die Temperatur der Speicherzelle auf einen zwischen 353,15 K und 450 K enthaltenen Wert gebracht wird.

## Claims

1. An ionic conduction PMC memory comprising an inert cathode (6), a soluble anode (8) and a solid electrolyte (4) placed between said cathode and said anode, **characterized in that** it comprises a heat resistance (20) for heating the solid electrolyte, located near the active zone, for carrying the latter, transitionally during writing in the memory, at a writing temperature higher than its operating temperature outside the writing step.

2. The memory as claimed in Claim 1, the solid electrolyte comprising a material of chalcogenide type.

3. The memory as claimed in Claim 2, the solid electrolyte being an oxide, for example WO3.

4. The memory as claimed in Claim 2 or 3, the chalcogenide being doped with metal.

5. The memory as claimed in Claim 4, in which the metal-doped chalcogenide is of AgGeSe type.

6. The memory as claimed in Claim 4, in which the metal-doped chalcogenide is of AgGeSbSe type.

7. The memory as claimed in Claim 4, in which the metal-doped chalcogenide is of AgGeS type.

8. The memory as claimed in Claim 2, in which the chalcogenide is of AsS type.

9. The memory as claimed in Claim 4, in which the metal-doped chalcogenide is of copper-doped AsS type.

10. The memory as claimed in any one of Claims 1 to 9, further comprising means (30) forming a thermal barrier on the side opposite to the inert cathode (6).

11. The memory as claimed in any one of Claims 1 to 10, the heat resistance (20) being placed in contact with the inert cathode (6).

12. The memory as claimed in any one of Claims 1 to 11, the heat resistance (20) being separated from the inert cathode (6) by at least one contact electrode (22) of the inert cathode (6).

13. The memory as claimed in any one of Claims 1 to 12, comprising a first contact, a second contact and a third contact (10, 16, 18), the first contact and the second contact (10, 16) being for applying a voltage between the inert cathode (6) and the soluble anode (8) for writing in the solid electrolyte (4), one of these two contacts being common with the heat resistance (20), the last one being able to be activated by application of the heat resistance (20) .

14. The memory as claimed in any one of Claims 1 to 12, comprising 4 contacts (10, 16, 17, 18), of which two contacts (10, 16) for applying a voltage between the inert cathode (6) and the soluble anode (8) for writing in the solid electrolyte (4), and two contacts (17, 18) for activating the heat resistance (20) .

15. Memory matrix of ionic conduction type as claimed in any one of Claims 1 to 14, comprising addressing means for lines (WL), addressing means for columns (BL), and addressing means for heat resistances (20) .

16. Method for working a PMC memory as claimed in any one of Claims 1 to 14, in which, during writing in the memory:
- a writing voltage is applied to the solid electrolyte (4),
- with help of the heat resistance (16, 18, 20), the solid electrolyte (4) is carried transitionally at a writing temperature higher than its operating temperature outside the writing step.

17. The method as claimed in Claim 16, wherein, during writing, the temperature of the electrolyte is carried to between 353,15 K and 450 K.
